Europäisches Patentamt

European Patent Office

Office européen des brevets

(11) Publication number: **0 204 004 B1**

(12) **EUROPEAN PATENT SPECIFICATION**

(45) Date of publication of patent specification: **26.02.92**  (51) Int. Cl.⁵: **H05K 1/02**, H05K 3/46, H01L 27/13

(21) Application number: **85906087.3**

(22) Date of filing: **28.11.85**

(86) International application number:
**PCT/JP85/00661**

(87) International publication number:
**WO 86/03365 (05.06.86 86/12)**

(54) **WIRING STRUCTURE OF A TERMINAL CIRCUIT.**

(30) Priority: **29.11.84 JP 253562/84**

(43) Date of publication of application:
**10.12.86 Bulletin 86/50**

(45) Publication of the grant of the patent:
**26.02.92 Bulletin 92/09**

(84) Designated Contracting States:
**CH DE FR GB IT LI NL SE**

(56) References cited:
**JP-B- 517 824**
**US-A- 4 245 273**

**IBM TECHNICAL DISCLOSURE BULLETIN, vol. 22, no. 5, October 1979, pages 1841-1842, New York, US; A.H. JOHNSON et al.: "Multilayer ceramic fixed layer substrate design"**

(73) Proprietor: **FUJITSU LIMITED**
**1015, Kamikodanaka Nakahara-ku**
**Kawasaki-shi Kanagawa 211(JP)**

(72) Inventor: **NISHIHARA, Mikio Kopo Masaki 201**
**3-12-7, Kyodo Setagaya-ku**
**Tokyo 156(JP)**
Inventor: **KUWABARA, Kiyoshi Fujitsu Nagat-suta Shataku 202**
**5-4, Ibukino Midori-ku, Yokohama-shi**
**Kanagawa 227(JP)**

(74) Representative: **Sunderland, James Harry et al**
**HASELTINE LAKE & CO Hazlitt House 28**
**Southampton Buildings Chancery Lane**
**London WC2A 1AT(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

ELEKTRONIK, vol. 29, no. 21, October 1980, pages 125-128, Munich, DE; H. KRUMM: "Bessere Leiterplattenausnutzung mit neuem Mehrchip-IC-Gehäuse"

IEEE TRANSACTIONS ON COMPONENTS, HYBRIDS AND MANUFACTURING TECHNOLOGY, vol. CHMT-3, no. 4, December 1980, pages 634-637, New York, US; A.J. BLODGETT Jr.: "A multilayer ceramic multichip module"

## Description

The present invention relates to improvement in the wiring structure provided between integrated circuits (hereinafter referred to as LSIs) and termination circuits mounted on multilayered printed circuits boards, and more particularly concerns a wiring structure for a termination circuit which structure provides for improved quality and performance of printed circuit boards by reducing the amount of wiring in signal layers of the printed circuit board.

Recently, printed circuit boards mounting many LSIs are widely used. Since LSIs are mounted with corresponding termination circuits, circuit wiring in printed circuit boards is becoming more and more complicated.

Particularly, in a case in which a circuit wiring pattern which connects a through hole for a general circuit (e.g. an LSI) and a through hole for a termination circuit exists in the signal layers of a printed circuit board, the following problems occur:-

1. Conductor impedance between termination circuit and LSI becomes high;

2. Interference between circuits in the signal layers increases.

Moreover, in the structure described above, since the quantity of required circuit wirings to the termination circuit inevitably increases with increase in the quantity of wirings of each LSI, an adverse circumstance arises in that the circuit wirings of the signal layers in the printed circuit board become more and more complicated.

It is an object of the present invention to solve the problems described above, namely to suppress increase in the quantity of circuit wirings in the signal layers in a multilayered printed circuit board.

According to the present invention, there is provided a multilayered printed circuit board, having a leadout layer, nearest to the part-mounting surface of the board, and a signal layer below the leadout layer away from the part-mounting surface, the board mounting integrated circuits and termination circuits connected electrically by wiring patterns formed within the board and through holes in the board, characterised in that the wiring patterns which connect the integrated circuits and termination circuits are all provided in the leadout layer, and comprise fixed wiring patterns.

Thus, in comparison with the prior art, the present invention provides a structure for a multilayered printed circuit board, which board mounts an LSI connected electrically through through holes and a termination circuit, such that circuit wirings electrically connecting the termination circuit and the LSI and the through holes are replaced with a fixed pattern using a leadout layer, nearest to the surface of said multilayered printed circuit board, rather than signal layers within the board.

The most distinctive characteristic of the present invention is that congestion of circuits in signal layers, where the circuit wirings for LSIs are concentrated, is alleviated by shifting the wiring position of termination circuit wiring pattern of the multilayered printed circuit board to the leadout layer, nearest to the surface of the printed circuit board, from the signal layers of the circuit board.

Figs. 1 are provided for assistance in explaining the termination circuit wiring structure of an embodiment of the present invention: Fig. 1A is a plan view of main parts of the embodiment, whilst Fig. 1B is a side sectional view of main parts,

Figs. 2 are provided for assistance in explaining a termination circuit wiring structure of the prior art: Fig. 2A is a plan view of main parts of the structure, whilst Fig. 2B is a side sectional view of main parts.

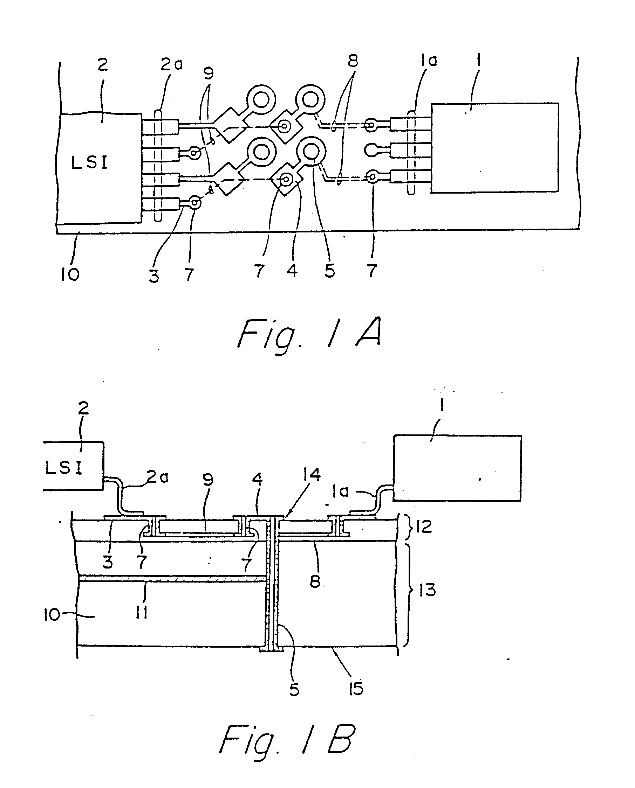

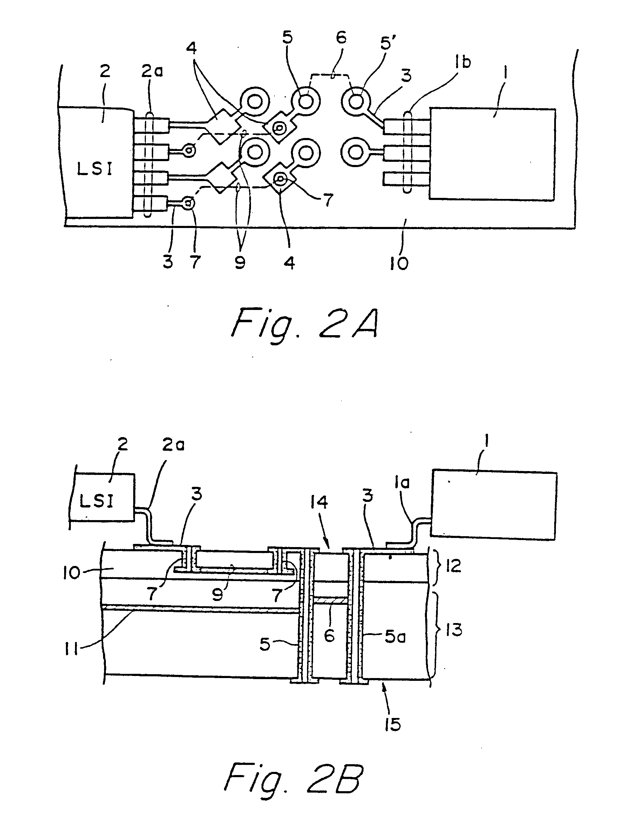

In Figs. 1 and 2, similar reference signs designate similar items.

First, a wiring structure for a termination circuit which provides the background prior art of the present invention will be explained with reference to Figs. 2.

Fig. 2A and Fig. 2B illustrate the most typical termination circuit wiring structure of the prior art.

The multilayer printed circuit board 10 of Figs. 2 has internal layers 12 and 13, layer 12 being a leadout layer nearest the part-mounting surface 14 of the board and layer 13 being a signal layer below the leadout layer 12. The board 10 also has conductors formed on the part-mounting surface 14 (e.g. lead patterns 3 and bonding pads 4).

In the structure of Figs. 2, a circuit wiring pattern 6 is provided in the signal layer 13 of the internal layers of printed circuit board 10 in order to connect a through hole 5 for a general circuit (e.g. an LSI) and a through hole 5a for a termination circuit. As shown in Fig. 2B, a general circuit wiring pattern 11 between LSIs is provided in the signal layer 13.

Many conductors such as a lead pattern 3, blind through holes 7, leadout pattern 9, bonding pads 4, through hole 5 for a general circuit, circuit wiring pattern 6 and through hole 5a for a termination circuit are used for connecting a signal terminal 2a of an LSI 2 and a terminal 1a of a termination circuit 1 mounted on the multilayered printed circuit board 10.

Therefore, when the circuit wiring pattern 6 for connecting the through hole 5 for a general circuit and the through hole 5a for a termination circuit exist as shown in Fig. 2B in the signal layer 13 of said printed circuit board, following problems are generated:-

1. Conductor impedance between the termination circuit 1 and LSI 2 becomes high;

2. Interference between circuits in the signal layer 13 increases.

According to the wiring structure of the present invention, such problems can be eliminated.

A preferred embodiment of the present invention will be explained in detail with reference to Figs. 1.

As shown in Fig. 1A and Fig. 1B, in the termination circuit wiring structure of this embodiment of the present invention a fixed pattern 8 which electrically connects termination circuit 1 and the through hole 5, through a blind through hole 7, is provided within leadout layer 12 nearest to the part-mounting surface 14 of the multilayered printed circuit board.

Namely, the termination circuit wiring structure of the present invention is characterised in that a circuit wiring pattern 6 present in the prior art of Fig. 2 is replaced by a fixed pattern 8 by shifting the position to the leadout layer 12 from the signal layer 13.

Thereby, wiring to the termination circuit 1 is eliminated from the signal layer 13 and a general circuit such as LSI 1 is wired more effectively to the signal layer 13 than in the prior art.

The blind through hole 7 described above is not bored through both front (14) and rear (15) surfaces of the printed circuit board 10 (i.e. does not extend completely through the board) and is a so-called "short-leg type" special through hole providing electrical connection between the lead pattern 3, bonding pad 4 and leadout pattern 9 and between the terminal 1a and circuit pattern 8. Therefore, this through hole has the merits that it can avoid interference with the other through hole 5 bored through the front and rear surfaces of the board (i.e. extending completely through the board) and extra space made available in signal layers 13 can be used effectively.

As described above, the wiring structure of an embodiment of the present invention provides that the signal wiring density of the printed circuit board can be improved remarkably by shifting the termination circuit wiring pattern, which has previously been provided at the signal layers, to the leadout layer nearest to the surface of multilayered printed circuit board.

The wiring structure of a termination circuit, provided by an embodiment of the present invention, can be used for multilayered printed circuit of any type and particularly is effective for a printed circuit board having a high density wiring pattern mounting LSIs.

## Claims

1. A multilayered printed circuit board, having a leadout layer (12), nearest to the part-mounting surface (14) of the board, and a signal layer (13) below the leadout layer (12) away from the part-mounting surface (14), the board (10) mounting integrated circuits (2) and termination circuits (1) connected electrically by wiring patterns (8, 9) formed within the board and through holes (5, 7) in the board, characterised in that the wiring patterns (8, 9) which connect the integrated circuits (2) and termination circuits (1) are provided in the leadout layer (12), and comprise fixed wiring patterns (8).

2. A board as claimed in claim 1, further comprising conductors formed on the part-mounting surface (14) of the board (10), electrically connected to the fixed wiring patterns (8) by way of blind through holes (7), which through holes do not extend completely through the board (10).

## Revendications

1. Plaquette de circuit imprimé multicouche, comportant une couche de conducteurs de sortie (12), au plus près de la surface (14) de la plaquette servant au montage des pièces, et une couche de signaux (13) située en dessous de la couche (12) de conducteurs de sortie, à distance de la surface (14) servant au montage des pièces, la plaquette (10) comprenant des circuits intégrés (2) et des circuits de bornage (1) reliés électriquement par des configurations de câblage (8, 9) formées à l'intérieur de la plaquette et des trous métallisés (5, 7) dans la plaquette, plaquette caractérisée par le fait que les configurations de câblage (8, 9) qui relient les circuits intégrés (2) et les circuits de bornage (1) sont prévues dans la couche (12) de conducteurs de sortie et sont constituées de configurations de câblage fixes (8).

2. Plaquette comme revendiqué dans la revendication 1, comportant en outre des conducteurs formés sur la surface (14) de la plaquette (10) servant au montage des pièces, et électriquement reliés aux configurations fixes (8) de câblage au moyen de trous métallisés borgnes (7) qui ne s'étendent pas complètement à travers la plaquette (10).

## Patentansprüche

1. Mehrschichtige gedruckte Schaltungskarte, mit einer Herausführungsschicht (12), der Teilemontageoberfläche (14) der Karte am nächsten, und einer Signalschicht (13) unterhalb der Herausführungsschicht (12), von der Teilemontageoberfläche (14) entfernt, welche Karte (10) integrierte Schaltungen (2) und Abschlußschaltungen (1) trägt, die elektrisch durch Verdrahtungsmuster (8, 9) verbunden sind, die innerhalb der Karte gebildet sind, und durch Löcher (5, 7) in der Karte, dadurch gekennzeichnet, daß die Verdrahtungsmuster (8, 9), welche die integrierten Schaltungen (2) und die Abschlußschaltungen (1) verbinden, in der Herausführungsschicht (12) vorgesehen sind und fixierte Verdrahtungsmuster umfassen.

2. Karte nach Anspruch 1, ferner mit Leitern, die auf der Teilemontageoberfläche (14) auf der Karte (10) gebildet sind und mit den fixierten Verdrahtungsmustern (8) über blinde Durchgangslöcher (7) elektrisch verbunden sind, welche Durchgangslöcher sich nicht vollständig durch die Karte (10) hindurcherstrecken.

Fig. 1 A

Fig. 1 B

Fig. 2A

Fig. 2B